Europäisches Patentamt

European Patent Office

Office européen des brevets

(19)

(11) Veröffentlichungsnummer: **0 430 322 A2**

(12) # EUROPÄISCHE PATENTANMELDUNG

(21) Anmeldenummer: **90202984.2**

(22) Anmeldetag: **12.11.90**

(51) Int. Cl.⁵: **G01R 33/56**

(30) Priorität: **18.11.89 DE 3938370**

(43) Veröffentlichungstag der Anmeldung:
**05.06.91 Patentblatt 91/23**

(84) Benannte Vertragsstaaten:
**DE FR GB NL Patentblatt 4**

(71) Anmelder: **Philips Patentverwaltung GmbH**
**Wendenstrasse 35 Postfach 10 51 49**
**W-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **Kuhn, Michael, Dr.**
**Süntelstrasse 77**
**W-2000 Hamburg 61(DE)**

(74) Vertreter: **Hartmann, Heinrich, Dipl.-Ing. et al**
**Philips Patentverwaltung GmbH**
**Wendenstrasse 35 Postfach 10 51 49**
**W-2000 Hamburg 1(DE)**

(54) **Kernspintomographieverfahren und Kernspintomograph zur Durchführung des Verfahrens.**

(57) Die Erfindung betrifft ein Kernspintomographieverfahren, bei dem in Anwesenheit eines stationären homogenen Magnetfeldes auf ein Untersuchungsobjekt eine Vielzahl von Sequenzen einwirkt, von denen jede das Erzeugen eines magnetischen Hochfrequenzimpulses in Verbindung mit einem ersten magnetischen Gradientenfeld und das unter Einschaltung eines zweiten magnetischen Gradientenfeldes mit einem zu dem Gradienten des ersten Feldes senkrechten Gradienten erfolgenden Auslesen eines Kernresonanzsignals umfaßt, wobei aus den Kernresonanzsignalen durch Fouriertransformation ein Bild der Kernmagnetisierungsverteilung rekonstruiert wird. Um damit in kürzestmöglicher Zeit ein Übersichtsbild zu erzeugen, ist vorgesehen, daß während der Untersuchung das Untersuchungsobjekt in der Richtung des Gradienten des ersten magnetischen Gradientenfeldes verschoben wird und daß das Bild der Kernmagnetisierungsverteilung zeilenweise durch eine eindimensionale Fouriertransformation des jeweils erhaltenen Kernresonanzsignals rekonstruiert wird.

Fig.4

EP 0 430 322 A2

# KERNSPINTOMOGRAPHIEVERFAHREN UND KERNSPINTOMOGRAPH ZUR DURCHFÜHRUNG DES VERFAHRENS

Die Erfindung betrifft ein Kernspintomographieverfahren, bei dem in Anwesenheit eines stationären homogenen Magnetfeldes auf ein Untersuchungsobjekt eine Vielzahl von Sequenzen einwirkt, von denen jede das Erzeugen eines magnetischen Hochfrequenzimpulses in Verbindung mit einem ersten magnetischen Gradientenfeld und das Auslesen eines Kernresonanzsignals unter Einschaltung eines zweiten magnetischen Gradientenfeldes mit einem zu dem Gradienten des ersten Feldes senkrechten Gradienten umfaßt, wobei das Objekt in der Richtung des Gradienten des ersten magnetischen Gradientenfeldes verschoben wird und das Bild der Kernmagnetisierungsverteilung zeilenweise durch eine eindimensionale Fouriertransformation des jeweils erhaltenen Kernresonanzsignals rekonstruiert wird sowie einen Kernspintomographen zur Durchführung des Verfahrens. Ein solches Verfahren und eine solche Anordnung sind aus der DE-OS 31 24 435 bekannt.

In der medizinischen Praxis besteht oft das Bedürfnis nach einem Übersichtsbild, das einen diagnostisch relevanten Bereich mit Sicherheit enthält. Solche Übersichtsbilder werden in der Rönten-Computertomographie dadurch erhalten, daß ein Patient von einem Röntgenstrahlenfächer durchsetzt wird und dabei senkrecht zu dem Fächer verschoben wird. Das auf diese Weise erhaltene sogenannte Scanogramm stellt eine zur Tischplatte senkrechte Projektion der Röntgenstrahlenabsorptionsverteilung dar.

Mit dem bekannten Kernspintomographieverfahren ergibt sich zwar auch ein Projektionsbild (der Kernmagnetisierungs verteilung) des Patienten, doch ist dieses praktisch nicht interpretierbar, da alle Weichteilgewebe ein sehr hohes Signal erzeugen - im Gegensatz zu einem Röntgen-Scanogramm, bei dem nur die Knochen für die Bildgebung wesentlich sind.

Es ist Aufgabe der vorliegenden Erfindung, ein Verfahren der eingangs genannten Art so auszugestalten, daß ein diagnostisch interpretierbares Übersichtsbild in relativ kurzer Zeit angefertigt werden kann, und eine zur Durchführung des Verfahrens geeignete Anordnung anzugeben.

Diese Aufgabe wird erfindungsgemäß dadurch gelöst, daß vor den Anregungssequenzen eine Sättigungssequenz durchgeführt wird, durch die die Kernmagnetisierung überall außerhalb einer zu den Richtungen der beiden Gradienten parallelen Schicht dephasiert wird. Durch die Erfindung wird also die Kernmagnetisierung überall außerhalb einer zur Verschiebungsrichtung parallelen Schicht dephasiert. Das mit den anschließenden Anregungssequenzen erzeugte Bild stellt daher nur ein Projektionsbild innerhalb dieser Schicht dar. Durch geeignete Wahl der Dicke dieser Schicht kann ein Übersichtsbild mit dem Charakter eines leicht zu interpretierenden Scannogramms erhalten werden.

Wenn dabei zwischen der Anregung der ersten und der letzten Schicht ein relativ großer Zeitraum verstreicht, kann die Dephasierung der Kernmagnetisierung außerhalb der Schicht schon vor dem Erreichen der letzten Schicht zerfallen sein, so daß auch die Bereiche außerhalb der Schicht einen Beitrag zu dem jeweiligen Kernresonanzsignal liefern. Dies läßt sich in weiterer Ausgestaltung der Erfindung dadurch verhindern, daß nach jeweils mehreren Anregungssequenzen je eine weitere Sättigungssequenz durchgeführt wird.

Hierbei würde eine zuvor noch nicht angeregte Schicht das Isozentrum während einer Sättigungssequenz passieren, wenn die Verschiebung während dieser Sequenz anhalten würde. Wenn die nach dieser weiteren Sättigungssequenz folgenden Anregungssequenzen mit den davor erzeugten Anregungssequenzen identisch wären, würde der das Isozentrum während einer Sättigungssequenz passierende Bereich nicht abgebildet werden. Dies könnte dadurch vermieden werden, daß die Verschiebung während jeder weiteren Sättigungssequenz unterbrochen wird. Dabei würden jedoch Verzögerungs- und Beschleunigungskräfte auf das Untersuchungsobjekt einwirken, die im Kernspintomogramm Bewegungsartefakte hervorrufen könnten.

Um solche Artefakte zu vermeiden, sieht eine Weiterbildung der Erfindung vor, daß - bei fortdauernder Verschiebung des Untersuchungsobjekts - nach jeder weiteren Sättigungssequenz die Frequenz der Hochfrequenzimpulse der Anregungssequenzen derart geändert wird, daß die dadurch angeregten Schichten sich unmittelbar an die vor der Sättigungssequenz angeregten Schichten anschließen.

Eine Anordnung zur Durchführung des Verfahrens ist gekennzeichnet durch einen Magneten zur Erzeugung eines homogenen stationären Magnetfeldes, eine Spulenanordnung zur Erzeugung magnetischer Hochfrequenzimpulse, Gradientenspulenanordnungen zur Erzeugung von in Richtung des homogenen stationären Magnetfeldes verlaufenden Magnetfeldern mit in unterschiedlichen Richtungen verlaufenden Gradienten, einer Fouriertransformationsanordnung zur Durchführung einer eindimensionalen Fouriertransformation der Kernresonanzsignale, einer Lagerungsanordnung für das Untersuchungsobjekt, Antriebsmitteln zur Verschiebung der Lagerungsanordnung während einer Untersuchung und durch eine Steuereinheit, die die Antriebseinheit, die Gradien tenspulenanordnungen, die Hochfrequenzspulenanordnung und die Fouriertransformationsanordnung so steuert, daß zunächst eine Sättigung der Kernmagnetisierung außerhalb einer die Verschiebungsrichtung enthaltenden Schicht durchgeführt wird und anschließend das Objekt in der Richtung eines Gradienten in der Verschiebungsrichtung verschoben wird und das Bild der Kernmagnetisierung zeilenweise durch eine eindimensionale Fouriertransformation des jeweils erhaltenen Kernresonanzsignals rekonstruiert wird.

Die Erfindung wird nachstehend anhand der Zeichnung näher erläutert. Es zeigen

Fig. 1 ein Kernspintomographiegerät, mit dem die Erfindung durchführbar ist,

Fig. 2 ein Blockschaltbild eines solchen Gerätes,

Fig. 3 die zeitliche Lage verschiedener Signale bei einer Sättigungssequenz und

Fig. 4 die zeitliche Lage der entsprechenden Signale bei zwei aufeinanderfolgenden Anregungssequenzen.

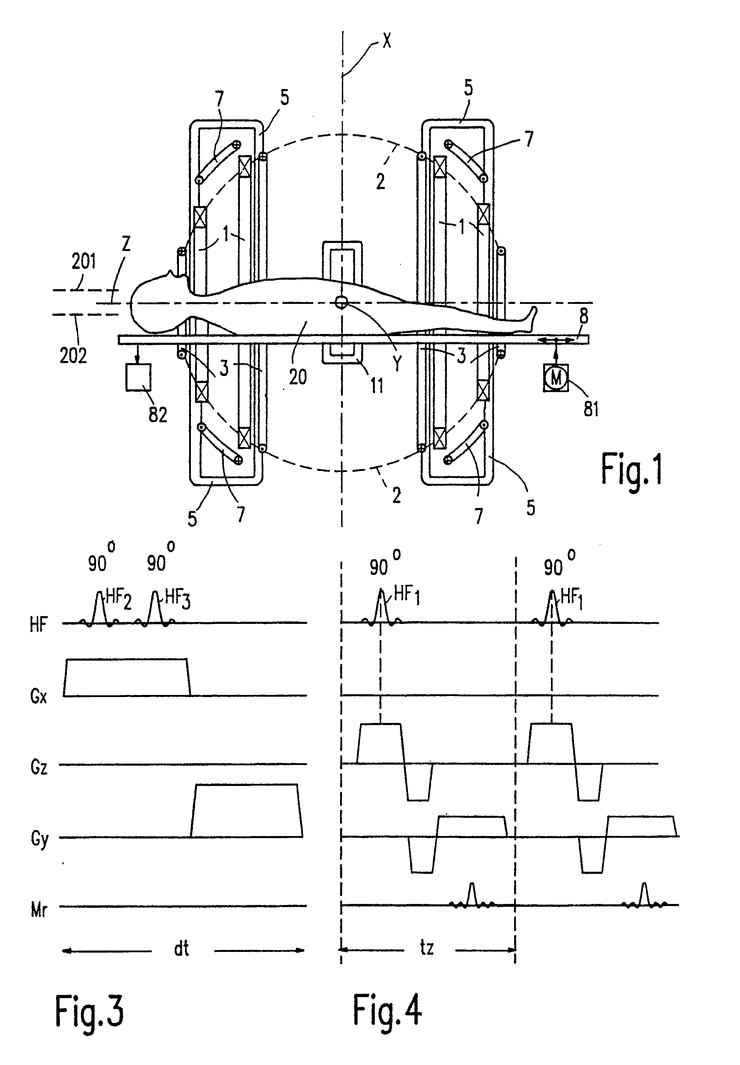

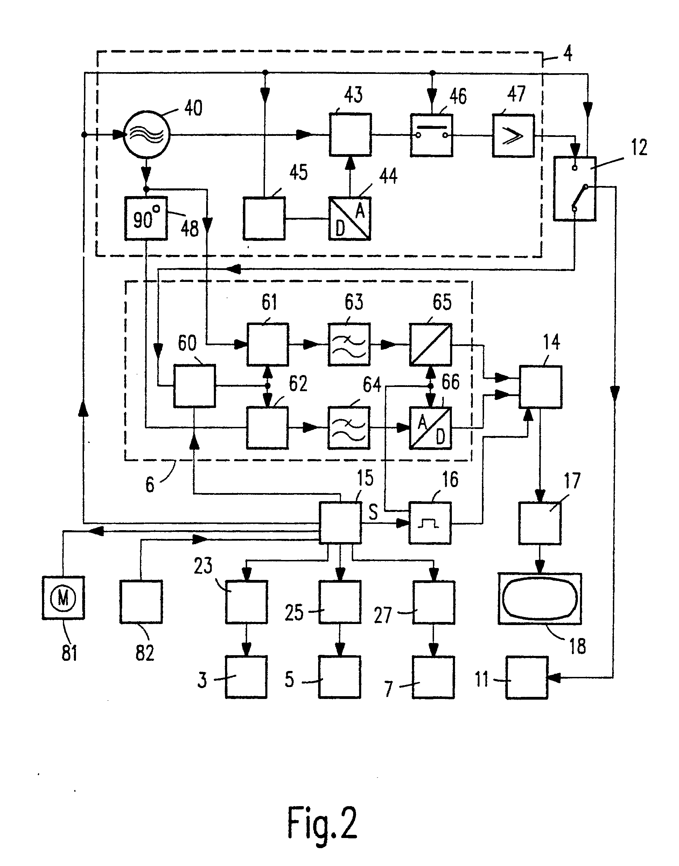

Der in Fig. 1 schematisch dargestellte Kernspintomograph enthält eine aus vier Spulen 1 bestehende Anordnung zur Erzeugung eines homogenen stationären Magnetfeldes, das Bruchteile von Tesla, aber auch einige Tesla stark sein kann. Dieses Feld verläuft in z-Richtung eines kartesischen Koordinatensystems. Die zur z-Achse konzentrisch angeordneten Spulen können auf der Oberfläche 2 einer Kugel angeordnet sein, deren Mittelpunkt das sogenannte Isozentrum bildet.

Im Innern dieser Spulen befindet sich der zu untersuchende Patient 20, der auf einer Tischplatte 8 gelagert ist. Die Tischplatte 8 ist mittels eines Motorantriebs 81 in z-Richtung, d.h. in Längsrichtung des Patienten verschiebbar. Ein Positionsgeber 82 erzeugt dabei ein der jeweiligen Position der Tischplatte 8 entsprechendes elektrisches Signal. Zusätzlich sind an sich bekannte und daher nicht näher dargestellte Mittel vorgesehen, mit denen der Untersucher vorgeben kann, wieweit der Patient 20 auf der Tischplatte 8 in den durch die Spulen 1 gebildeten Magneten hineingefahren wird. Diese Mittel können beispielsweise einen Laser umfassen, der z.B. ein Kreuz auf den Patienten projiziert sowie einen Speicher, in dem die Tischplattenposition gespeichert wird, wenn das Laserkreuz die richtige Position erreicht hat, und der Benutzer ein entsprechendes Kommando gibt. Die so markierte Position kann am vorderen oder am hinteren Rand, jedoch auch in der Mitte des zu erzeugenden Übersichtsbildes liegen.

Zur Erzeugung eines in z-Richtung verlaufenden und sich in dieser Richtung linear ändernden Magnetfeldes Gz sind vier Spulen 3 vorzugsweise auf der gleichen Kugeloberfläche 2 angeordnet.

Weiterhin sind vier Spulen 7 vorgesehen, die ein ebenfalls in z-Richtung verlaufendes magnetisches Gradientenfeld (d.h. ein Magnetfeld, dessen Stärke sichin einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, jedoch diesen gegenüber um 90° versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy, Gx symmetrisch zur Kugeloberfläche 2 angeordnet ist, ist die Feld stärke in Kugel- bzw. Isozentrum, das gleichzeitig den Ursprung des erwähnten kartesischen x-y-z-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule 11 wird während jedes Hochfrequenzimpulses ein hochfrequenter modulierter Strom von einem Hochfrequenzgenerator zugeführt. Im Anschluß an eine Sequenz dient die Hochfrequenzspule 11 oder eine gesonderte Hochfrequenz-Empfangsspule zum Empfangen der im Untersuchungsbereich erzeugten Kernresonanzsignale.

Fig. 2 zeigt ein vereinfachtes Blockschaltbild dieses Kernspintomographen. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in Frequenz und Phase durch eine Steuereinheit 15 digital steuerbaren Hochfrequenzoszillator 40, der Schwingungen mit einer Frequenz entsprechend der Larmorfrequenz der anzuregenden Atomkerne bei der von den Spulen 1 erzeugten Feldstärke liefert. Die Larmorfrequenz f berechnet sich bekanntlich nach der Beziehung $f = cB$, wobei B die magnetische Induktion des stationären homogenen Magnetfeldes darstellt und c das gyromagnetische Verhältnis, das beispielsweise für Protonen 42,56 mHz/T beträgt. Der Ausgang des Oszillators 40 ist mit einem Eingang einer Mischstufe 43 verbunden. Der Mischstufe wird ein zweites Eingangssignal von einem Digital-Analog-Wandler 44 zugeführt, dessen Ausgang mit einem digitalen Speicher 45 verbunden ist. In dem Speicher sind eine Anzahl von Hüllkurvensignalen - jedes als Folge digitaler Datenworte - gespeichert, von denen bei jeder Sequenz eins ausgelesen wird.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten Kernresonanzsignale zugeführt werden, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers 60 ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 900 besteht. Diese Phasenverschiebung wird mit Hilfe eines 900-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüber liegenden Frequenzen unterdrücken und niederfrequente Anteile durchlassen, je einem Analog-Digital-Wandler 65 bzw. 66 zugeführt. Dieser setzt die analogen Signale der einen Quadraturdemodulator bildenden Schaltung 61..64 in digitale Datenworte um, die einem Speicher 14 zugeführt werden. Die Analog-DigitalWandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von . der Hochfrequenzspule 11,gelieferten, in den Niederfrequenzbereich transponierten Signale in eine Folge digitaler Datenworte umgesetzt und in dem Speicher 14 gespeichert werden können.

Ein Rechner 17 errechnet aus jedem Kernresonanzsignal durch eine eindimensionale Fouriertransformation die Kernmagnetisierungsverteilung in einer zur z-Richtung senkrechten Zeile. Das Übersichtsbild entsteht aus einer Vielzahl solcher Zeilen.

Die Steuereinheit 15 steuert die Antriebseinheit 81 und verarbeitet die Signale des Positionsgebers, so daß es möglich ist, die Tischplatte 8 in eine definierte Position zu fahren.

Fig. 3 stellt die Lage verschiedener Signale bei einer Sättigungssequenz dar, die eine bestimmte Schicht innerhalb des Patienten 20 definiert, indem sie die Kernmagnetisierung im gesamten Untersuchungsbereich anregt und in den beiderseits der definierten Schicht befindlichen Bereichen dephasiert.

Diese in Fig. 3 dargestellte Sättigungssequenz umfaßt zwei Hochfrequenzimpulse HF2 und HF3, die von einem magnetischen Gradientenfeld Gx begleitet sind, dessen Gradient senkrecht zum Lesegradienten (4. Zeile von Fig. 4) verläuft, in diesem Fall also in x-Richtung (vergl. 2. Zeile).

Der Hochfrequenzimpuls HF2 ist hinsichtlich seiner Mittenfrequenz und seiner Bandbreite so gestaltet, daß er in Verbindung mit dem magnetischen Gradientenfeld Gx (2. Zeile) die Kernmagnetisierung in einem Bereich z.B. oberhalb einer in Fig. 1 durch die gestrichelte Linie 201 angedeuteten horizontalen Ebene anregt. Der Hochfrequenzimpuls HF3 hat eine solche Mittenfrequenz, daß in Verbindung mit dem magnetischen Gradientenfeld Gx die Kernmagnetisierung in einem Bereich angeregt wird, der sich unterhalb einer zweiten Schicht 202 (Fig. 1) befindet. Durch ein anschließend eingeschaltetes magnetisches Gradientenfeld Gy wird die Kernmagnetisierung in den Bereichen, in denen sie zuvor angeregt wurde, dephasiert, so daß bei den nachfolgenden Anregungssequenzen diese Bereiche keinen Beitrag zu dem Kernresonanzsignal liefern.

Die Dephasierung könnte auch durch Einschaltung eines magnetischen Gradientenfeldes Gz nach dem Hochfrequenzimpuls HF3 erfolgen oder dadurch, daß das Gradientenfeld Gx noch weiter verlängert wird.

Anstelle zweier Hochfrequenzimpulse HF2 und HF3 genügt auch die Erzeugung eines einzigen Hochfrequenzimpulses, wenn dessen Frequenzspektrum so beschaffen ist, daß dadurch gleichzeitig einerseits die Bereiche oberhalb der Schicht 201 und andererseits die Bereiche unterhalb der Schicht 202 angeregt werden. Dies setzt voraus, daß in dem Speicher 45 eine entsprechend komplexe Umhüllende gespeichert ist. Ein derartiges Verfahren zur Sättigung ist an sich bekannt (vergl. DE-A 36 04 281).

Eine weitere Möglichkeit, die Kernmagnetisierung in den Bereichen außerhalb der durch die Ebenen 201 und 202 definierten Schicht zu dephasieren, besteht darin, zunächst einen ersten 90°-

Hochfrequenzimpuls zu erzeugen, der die Kernmagnetisierung im gesamten Untersuchungsbereich anregt und anschließend einen zweiten schichtselektiven Hochfrequenzimpuls (d.h. einen Hochfrequenzimpuls in Begleitung eines magnetischen Gradientenfeldes), der die Kernmagnetisierung innerhalb der Schicht 201-202 wieder in z-Richtung zurückkippt. Die dann noch außerhalb dieser Schicht bestehende Anregung wird durch anschließend eingeschaltete magnetische Gradientenfelder wieder dephasiert.

Anschließend werden Anregungssequenzen erzeugt, wodurch sich eine Projektion der Kernmagnetisierungsverteilung innerhalb der erwähnten Schicht auf eine zur z-Richtung parallele Ebene ergibt.

Fig. 4 stellt die Lage verschiedener Signale bei zwei aufeinanderfolgenden Anregungssequenzen dar. Während dieser Anregungssequenzen wird die Tischplatte 8 mit konstanter Geschwindigkeit v verschoben. Jede Anregungssequenz umfaßt einen Hochfrequenzimpuls HF1 (erste Zeile), der in Verbindung mit dem magnetischen Gradientenfeld Gz (dritte Zeile) als schichtselektiver Hochfrequenzimpuls wirksam ist, der in einer zur z-Richtung (d.h. zur Verschiebungsrichtung der Tischplatte 8) senkrechten Schicht die Kernmagnetisierung vorzugsweise um 90° kippt. Die Mittenfrequenz des Hochfrequenzimpulses HF1 ist vorzugsweise so gewählt, daß die dadurch angeregte Schicht im Isozentrum liegt. Die Bandbreite des Hochfrequenzimpulses HF1 und der Gradient Gz sind vorzugsweise so gewählt, daß die Dicke der Schicht der Strecke $v\,t_z$ entspricht, die die mit der Geschwindigkeit v verfahrene Tischplatte 8 innerhalb der Dauer $t_z$ einer Sequenz zurücklegt.

Nach dem Hochfrequenzimpuls HF1 wird ein magnetisches Gradientenfeld mit zur z-Richtung senkrecht verlaufendem Gradienten wirksam, in diesem Fall das magnetische Gradientenfeld Gy (4. Zeile). Die Polarität dieses Feldes wird einmal umgekehrt, und zwar derart, daß das zeitliche Integral über dieses Gradientenfeld vor dem Polaritätswechsel halb so groß ist wie das entsprechende Integral nach dem Polaritätswechsel. Nach dem Polaritätswechsel und bei konstantem Gy wird das in der angeregten Schicht entstehende Kernresonanzsignal, (5. Zeile) ausgelesen, d.h. die Steuereinrichtung gibt den Taktimpulsgenerator 16 frei, so daß das in eine Folge digitaler Datenworte umgesetzte Kernresonanzsignal einer (eindimensionalen) Fouriertransformation unterzogen werden kann.

Anschließend folgt die nächste Anregungssequenz mit identischen Parametern. Durch diese Anregungssequenz wird die benachbarte Schicht angeregt, die sich dann im Isozentrum befindet. Da aufeinanderfolgende Anregungssequenzen nicht die gleichen, sondern benachbarte Schichten anregen, kann der zeitliche Abstand zwischen zwei Anregungssequenzen und damit die Dauer $t_z$ klein gehalten werden, z.B. zwischen 10 und 20 ms. Mit einer Tischplattengeschwindigkeit v zwischen 100 mm/s und 200 mm/s ergeben sich dabei Schichtdicken (bzw. Zeilenbreiten) zwischen 1 mm und 4 mm. Werden bei ununterbrochener Verschiebung der Tischplatte fortlaufend weitere Anregungssequenzen erzeugt, dann ergibt sich ein Übersichtsbild, das einen Bereich des Patienten abbildet, der der Schichtdicke und der Zahl der Anregungssequenzen proportional ist.

Wenn die Dauer des Untersuchungsverfahrens in der Größenordnung der Längsrelaxationszeit $T_1$ liegt, erreicht die dephasierte Kernmagnetisierung bei den am Ende der Untersuchung stattfindenden Anregungssequenzen wieder ihren ursprünglichen Zustand, und es ergibt sich ein Beitrag dieser Bereiche zum Kernresonanzsignal. Dieser Beitrag kann dadurch verhindert werden, daß nach jeder n-ten Anregungssequenz, wobei n eine geeignet gewählte ganze Zahl ist, eine Sättigungssequenz eingefügt wird. Da jede Sättigungssequenz eine endliche Dauer dt hat, innerhalb der der Patient bei andauernder Verschiebung der Tischplatte um die Strecke vdt verschoben wird, können Lücken im Bild entstehen. Diese Lücken könnten dadurch vermieden werden, daß die Tischplattenbewegung vor Beginn der Sättigungssequenz gestoppt und nach dem Ende der Sättigungssequenz wieder fortgeführt wird. Hierbei könnten sich Erschütterungen des Patienten ergeben, die zu Bewegungsartefakten in dem Kernspintomogramm führen.

Eine andere Möglichkeit besteht darin, die Tischplatte auch während der Sättigungssequenzen kontinuierlich zu verschieben und bei den darauffolgenden Anregungssequenzen die Mittenfrequenz des Hochfrequenzimpulses HF1 so zu verschieben, daß dann nicht mehr die Schicht im Isozentrum, sondern eine Schicht angeregt wird, die um den Betrag vdt außerhalb des Isozentrums liegt. Es werden dann innerhalb eines bestimmten Bereiches des Patienten die Schichten in lückenloser Folge angeregt.

Vorstehend wurde ein Verfahren beschrieben, bei dem die ausgewählte Schicht (201-202) parallel zur Tischebene verläuft. Es ist aber auch möglich, eine andere zur z-Richtung parallele Schicht auszuwählen, indem während der Hochfrequenzimpulse HF2 und HF3 ein magnetisches Gradientenfeld eingeschaltet wird, dessen Gradient senkrecht zur z-Richtung und unter einen von 0° und 180° (mit der Horizontalen) verschiedenen Winkel verläuft. Der Lesegradient (4. Zeile von Fig. 4) muß dann senkrecht zu diesem Gradienten und zur z-Richtung verlaufen.

**Ansprüche**

1. Kernspintomographieverfahren, bei dem in Anwesenheit eines stationären homogenen Magnetfeldes auf ein Untersuchungsobjekt (20) eine Vielzahl von Sequenzen einwirkt, von denen jede das Erzeugen eines magnetischen Hochfrequenzimpulses (HF1) in Verbindung mit einem ersten magnetischen Gradientenfeld (Gz) und das Auslesen eines Kernresonanzsignals unter Einschaltung eines zweiten magnetischen Gradientenfeldes mit einem zu dem Gradienten des ersten Feldes senkrech,ten Gradienten (Gy) umfaßt, wobei das Objekt in der Richtung des Gradienten (Gz) des ersten magnetischen Gradientenfeldes verschoben wird und das Bild der Kernmagnetisierungsverteilung zeilenweise durch eine eindimensionale Fouriertransformation des jeweils erhaltenen Kernresonanzsignals rekonstruiert wird, dadurch gekennzeichnet, daß vor den Anregungssequenzen eine Sättigungssequenz durchgeführt wird, durch die die Kernmagnetisierung überall außerhalb einer zu den Richtungen der beiden Gradienten parallelen Schicht (201,202) dephasiert wird.

2. Kernspintomographieverfahren nach Anspruch 1, dadurch gekennzeichnet, daß nach jeweils mehreren Anregungssequenzen je eine weitere Sättigungssequenz durchgeführt wird.

3. Kernspintomographieverfahren nach Anspruch 2 dadurch gekennzeichnet, daß - bei fortdauernder Verschiebung des Untersuchungsobjekts - nach jeder weiteren Sättigungssequenz die Frequenz der Hochfrequenzimpulse (HF1) der Anregungssequenzen derart geändert wird, daß die dadurch angeregten Schichten sich unmittelbar an die vor der Sättigungssequenz angeregten Schichten anschließen.

4. Anordnung zur Durchführung des Verfahrens nach Anspruch 1, gekennzeichnet durch einen Magneten (1) zur Erzeugung eines homogenen stationären Magnetfeldes, eine Spulenanordnung (11) zur Erzeugung magnetischer Hochfrequenzimpulse, Gradientenspulenanordnungen (3,5,7) zur Erzeugung von in Richtung des homogenen stationären Magnetfeldes verlaufenden Magnetfeldern mit in unterschiedlichen Richtungen verlaufenden Gradienten, einer Fouriertransformationsanordnung (17) zur Durchführung einer eindimensionalen Fouriertransformation der Kernresonanzsignale, einer Lagerungsanordnung (8) für das Untersuchungsobjekt (20), Antriebsmitteln (81) zur Verschiebung der Lagerungsanordnung während einer Untersuchung und durch eine Steuereinheit (15), die die Antriebseinheit (81), die Gradientenspulenanordnungen(3,5,7), die Hochfrequenzspulenanordnung (11) und die Fouriertransformationsanordnung (17) so steuert, daß zunächst eine Sättigung der Kernmagnetisierung außerhalb einer die Verschiebungsrichtung enthaltenden Schicht (201,202) durchgeführt wird und anschließend das Objekt in der Richtung eines Gradienten (Gz) in der Verschiebungsrichtung verschoben wird und das Bild der Kernmagnetisierung zeilenweise durch eine eindimensionale Fouriertransformation des jeweils erhaltenen Kernresonanzsignals rekonstruiert wird.

Fig.1

Fig.3

Fig.4

Fig.2